# EUROPEAN PATENT SPECIFICATION

(11) **EP 3 082 159 B1**
(45) Date of publication and mention of the grant of the patent: **22.05.2024**
(21) Application number: 15163928.3
(22) Date of filing: 16.04.2015
(51) Int. Cl.: H01L 23/40

(54) **FIXING DEVICE FOR FIXING A COMPONENT AGAINST AN ELEMENT**
BEFESTIGUNGSVORRICHTUNG ZUR BEFESTIGUNG EINER KOMPONENTE AN EINEM ELEMENT
DISPOSITIF DE FIXATION POUR PLACER UN COMPOSANT CONTRE UN ÉLÉMENT

(43) Date of publication of application: 19.10.2016
(73) Proprietor: Valeo Siemens eAutomotive France SAS, 95800 Cergy (FR)
(72) Inventor: SPANGBERG, Erik, 32 3038 Drammen (NO)
(74) Representative: Valeo Powertrain Systems

(56) References cited:
- DE-A1-102010 042 211
- DE-U1- 9 206 934
- FR-A3- 2 654 156
- US-A- 4 972 294
- "THE MAX CLIP SYSTEM(TM)", , 1 January 2005 (2005-01-01), pages 1-40, XP055042899, Retrieved from the Internet: URL:http://www.aavid.com/sites/default/fil es/literature/MaxClip-Extrusion-Profiles-C atalog.pdf [retrieved on 2012-11-01]

## Description

The invention relates to a fixing device for fixing a component configured to be mounted on a support against an element protruding from said support and to a method for fixing the component against the element thanks to such fixing device.

More particularly, the invention relates to the field of fixing device configured to fix a component to an element by pressing the component against the element. Advantageously, such fixing devices are often used in the electronics field and specifically for electronic devices used for power applications.

Indeed, in power applications, a heatsink is often used to remove continuously heat from the electronic devices, which need to be cooled because they do not perform well at elevated temperature. In order to remove heat from the electronic device in an efficient way, so as to keep the temperature thereof at safe levels, the electronic device should be attached to the heatsink in such a way that a sufficiently large surface portion of a heat transferring body of the electronic device is in direct contact with the heatsink itself.

According to a solution known in the art, a package of the electronic device is configured to be fastened to the heatsink by means of an insertable fastener, such as for example a screw, a rivet, configured to go through the body.

Nevertheless, the use of such insertable fasteners increases the risk of assembly defects and the material cost of manufacturing contact assemblies, as well as the labor cost.

The document FR 2654156 A3 discloses an electronic module comprising a positioning support for housing power components with an upper part having a hooking portion for fixing the power components by cooperating with a wall of the casing of the electronic module.

Still, there is a need for providing a reliable fixing device for fixing a component, configured to be mounted on a support against an element protruding from said support, which can be easily assembled without the use of special tools. To this end, the invention proposes a fixing device as claimed in claim 1. The fixing device according to the invention is adapted for fixing a component configured to be mounted on a support against an element protruding (perpendicularly) from said support, the fixing device especially comprising:
- a plate configured to receive the component along a surface of the component, and
- a retaining element arranged on a first end of the plate, and configured to cooperate with a complementary retaining element of the element to fix the component against the element when the component is mounted on the support,
- wherein the plate comprises a second end, notably opposite from the first end, configured to receive a portion of the component so that said portion protrudes from the plate for an insertion into a hole in the support when mounting the component on the support, and
- wherein the second end of the plate has a cross-section comprising at least a cylindrical portion configured to allow a pivot of the plate between a first position wherein the angle formed between the plate and the support is different from zero to a second position wherein the plate is substantially perpendicular to the support.

Advantageously, thanks to such fixing device a force is applied on the component to the element, taking account for mechanical tolerances and thermal variations. A correct force is obtained and assembly time in production is reduced. Furthermore, the fixing device according to the invention is also reliable in case of vibrations maintaining the component in position against the element.

No use of special tools is necessary and thus, the risk for metal particle inside the element and/or the component and so damage of the element and/or component are greatly reduced.

Moreover, the fixing device can be used to fix several components against the element at one time in order to have an efficient assembly process for mass production.

The fixing device according to the invention allows to obtain a compact assembly of the element and the component.

According to further embodiments which can be considered alone or in combination:
- the fixing device further comprises a pressing device configured to exert a force to press the component against the side wall of the element when the component is mounted on the support;
- said second end is configured to guide at least a rod extending beyond a lower face of the component and configured to be inserted into a through-hole of the support during its insertion into the through-hole of the support;
- an outer wall of the cylindrical portion defines a pivot surface along which the plate is configured to pivot between a first position wherein the angle formed between the plate and the support is different from zero to a second position wherein the plate is substantially perpendicular to the support;
- the plate comprises abutments defining a receiving area for receiving the component;
- said abutments are in contact with at least a portion of a periphery of the component when the component is received in the receiving area;
- the abutments comprise a horizontal abutment protruding from the face of the plate configured to be in contact with the component and configured to contact a bottom surface of the component when the component is received in the plate;
- the abutments comprise at least two vertical abutments, each protruding from the face of the plate configured to be in contact with the component and each configured to contact a lateral surface of the component when the component is received in the plate;
- the fixing device further comprises at least a fixing element configured to fix the component against the plate of the fixing device;
- the component comprises a back surface configured to contact the side wall of the element when the component is mounted on the support, a front surface opposed to the back surface, and a hole extending from the front surface to the back surface; and
- the fixing element comprises a pin extending from the face of the plate configured to be in contact with the component, said pin being configured to be inserted in the hole of the component and dimensioned such that the component is maintained against the plate;
- the component is maintained by a friction force between said pin and the hole;
- the fixing element comprises an element configured to be arranged on the plate to contact a periphery of the component when the component is received in the receiving area in order to maintain the component on the plate;
- the element comprises a clamp element having a C-shape configured to clamp the plate and to block an upper end of the component;
- the clamp comprises a through hole receiving a pin protruding from the plate when the clamp is mounted to block the clamp;
- the retaining element at the first end of the plate comprises a resilient lip configured to cooperate with a groove comprised in the complementary retaining element of the element;
- the fixing device is configured for fixing an electronic component configured to be mounted on an electronic board against an element being a heatsink protruding from said electronic board;
- the fixing device is configured for fixing an electronic component having at least an electrode forming the rod and configured to be mounted on the electronic board by insertion of the electrodes into through-holes of the electronic board.

Another object of the invention relates to an assembly for at least one component comprising an element and a fixing device for fixing each of the at least one component configured to be mounted on a support against an element protruding from said support as described hereinbefore according to the invention.

Particularly, the invention relates to an assembly for one or several electronic components comprising a heatsink and a fixing device as described hereinbefore according to the invention for fixing each of the at least one electronic component against the heatsink on an electronic board.

Another object of the invention relates to a method for fixing a component against an element on a support, the element comprising a fixing device according to the invention and as disclosed hereinbefore, further comprises a pressing device configured to exert a force to press the component against the side wall of the element when the component is mounted on the support, the method comprising at least the steps of:
a) providing the element, the component, the fixing device and the support on which the component is configured to be mounted;
b) fixing the component against the plate of the fixing device; and
c) engaging the retaining element with the complementary retaining element of the element to a position in which a back face of the component contacts a side wall of the element; and
d) pressing the component against the side wall of the element with the pressing device, after the step of engaging the retaining element of the plate with the complementary retaining element of the element.

According to further embodiments of the method according to the invention, which can be considered alone or in combination:
- the component comprises at least a rod extending beyond a lower face of the component and configured to be inserted into a through-hole of the support, the method further comprises a step of inserting the or each rod of the component into corresponding through-holes of the support before the step of engaging the retaining element of the plate with the complementary retaining element of the element;
- the plate comprises a second end notably opposite from the first end, and the step of inserting the or each rod of the component into corresponding through-holes of the support comprises at least the steps of:
   - positioning the fixing device such that the free extremity of the or each rod of the component are aligned with a corresponding through-hole of the support;
   - introducing the free extremity of the or each rod of the component into a corresponding through-hole of the support such that the second end of the fixing device comes into contact with the support; and
   - pivoting the plate of the fixing device around the second end such that the back face of the component contacts the side wall of the element.

Non limiting embodiments of the invention will now be described, by way of example only, and with reference to the following drawings in which:
- Figure 1 is a schematic representation of a fixing device according to an embodiment of the invention in use for fixing a component against an element
- Figure 2 to 4 illustrate different views of a first embodiment of a fixing device according to the invention;
- Figure 5 and 6 illustrate different views of a first embodiment of a fixing device according to the invention;
- Figures 7 to 9 are perspective views of three others embodiments of a fixing device according to the invention; and
- Figure 10 illustrates the assembling of at least a component maintained on the plate of the fixing device according to the invention against an element.

Elements in the figures are illustrated for simplicity and clarity and have not necessarily been drawn to scale. For example, the dimensions of some of the elements in the figure may be exaggerated relative to other elements to help improve the understanding of the embodiments of the present invention.

Certain terminology will be used in the following description for convenience in reference only and will not be limiting. For example, top, bottom, front, back, right and left refer to the invention in relation as orientated in the figures being referred to.

The invention relates to a fixing device for fixing a component configured to be mounted on a support against an element protruding from the support, preferably perpendicularly, from said support.

Advantageously, the fixing device is configured for fixing simultaneously several components and preferably two or three components, against the element.

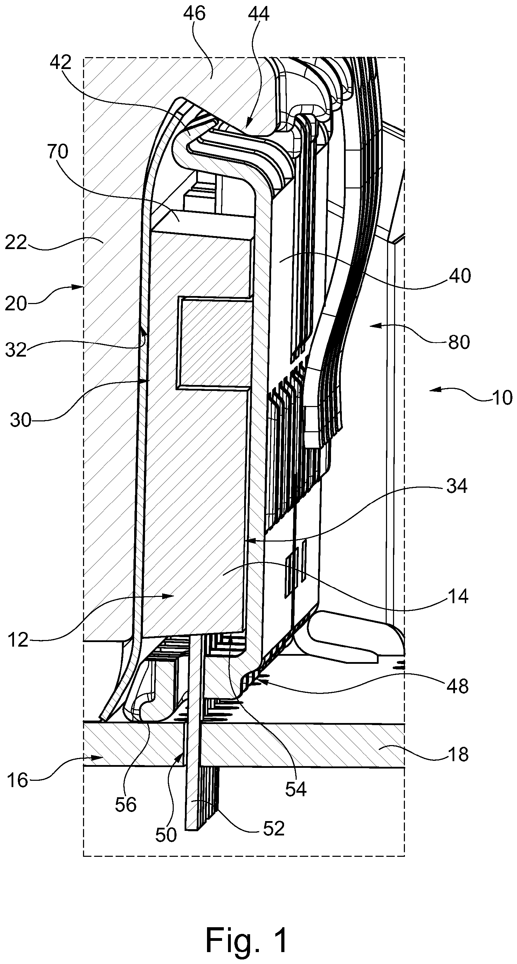

Figure 1 illustrates a fixing device 10 according to the invention used to fix a component against an element on a support, wherein the component 12 is an electronic component 14, for example used in power applications, the support 16 is an electronic board 18 and the element 20 is a heatsink 22 and . The heatsink 22 is configured to remove continuously heat produced by the electronic component 14 during use. The heatsink 22 is configured to protrude from the electronic board 18 when the electronic component 14 is mounted on the support 16 against the heatsink 22.

The electronic component 18 typically comprises a chip, for example a power component, on which electronic circuits are integrated and a package in which the chip is embedded for protecting it. The package comprises a body, which is particularly a heat transferring body, having exposed leads which are electronically connected to the chip and configured to be connected to external circuits. To this end, the electronic component is usually fixedly mounted on the support 16, typically a printed circuit board (PCB).

The body has a substantially flat back surface 30 which is configured to contact a surface 32 of the heatsink when the electronic component 14 is mounted on the PCB 18 for removing heat produced during operation of the electronic component.

Moreover, the body further comprises a front surface 34 which is configured to contact the fixing device 10.

The element 20, here the heatsink 22, comprises a side wall 32, preferably extending perpendicular to the support. The side wall 32 is configured to contact the back surface 30 of the electronic component 14 when the electronic component is pressed against the element. The side wall 32 may be covered by an electrically insulating sheet which ensures electrical insulation between the component and the heatsink. Preferably, this sheet has a width or is in a material allowing a heat transferring from the component to the heatsink.

The fixing device 10 comprises a plate 40 and a retaining element 42 arranged on a first end 44 of the plate. The plate 40 is configured to receive the component 12 along the front surface 34 of the component. The retaining element 42 is configured to cooperate with a complementary retaining element 46 of the element 20 to fix the component 12 against the element when the component is mounted on the support 16.

Preferably, the retaining element 42 at the first end 44 of the plate 40 comprises a resilient lip configured to cooperate with a groove comprised in the complementary retaining element 46 of the element 20, which protrudes from the side wall 32.

The plate 40 further comprises a second end 48, notably opposite from the first end 44, and configured to receive a portion of the component 12 so that said portion protrudes from the plate 40 for an insertion into a hole 50 in the support 16 when mounting the component in the support.

Advantageously, the second end 48 is configured to guide at least a rod 52 extending beyond a lower face 54 of the component and configured to be inserted into a through-hole 50 of the support during its insertion into the through-hole of the support.

More particularly, the second end 48 of the plate 40 extends perpendicularly from the portion of the plate configured to be in contact with the component and has a cross-section comprising at least a cylindrical portion 56 configured to allow a pivot of the plate 40 between a first position wherein the angle formed between the plate 40 and the support 16 is different from zero to a second position wherein the plate 40 is substantially perpendicular to the support 16.

Advantageously, an outer wall of the cylindrical portion 54 defines a pivot surface along which the plate 40 is configured to pivot between the first position to the second position.

Furthermore, the plate 40 comprises abutments defining a receiving area for receiving the component 12.

Moreover, the fixing device 10 comprises at least a fixing element configured to fix the component 12 against the plate 40 of the fixing device.

Thanks to the abutments and/or the fixing element, the movement of the component relative to the plate is restricted or impossible.

Advantageously, the fixing device 10 can further comprise a pressing device 80 configured to exert a force to press the component 12 against the side wall 32 of the element 20 when the component is mounted on the support and positioned against the element 20. For example, the pressing device 80 comprises a spring clip configured to exert a force to press the component 12 against the side wall 32 of the element 20 in a lock position when the component 12 is positioned against the element 20. Preferably, the force is according to a transverse direction, for example substantially perpendicular to the side wall. The fixing device 10, particularly the plate 40, can also be aimed at ensuring electrical insulation of the component 12 with respect to the pressing device 80.

Advantageously, the pressing device is configured for pressing simultaneously several components against the element.

Moreover, to have a cost and an assembly method efficient the pressing device 80 is made of a spring steel sheet metal.

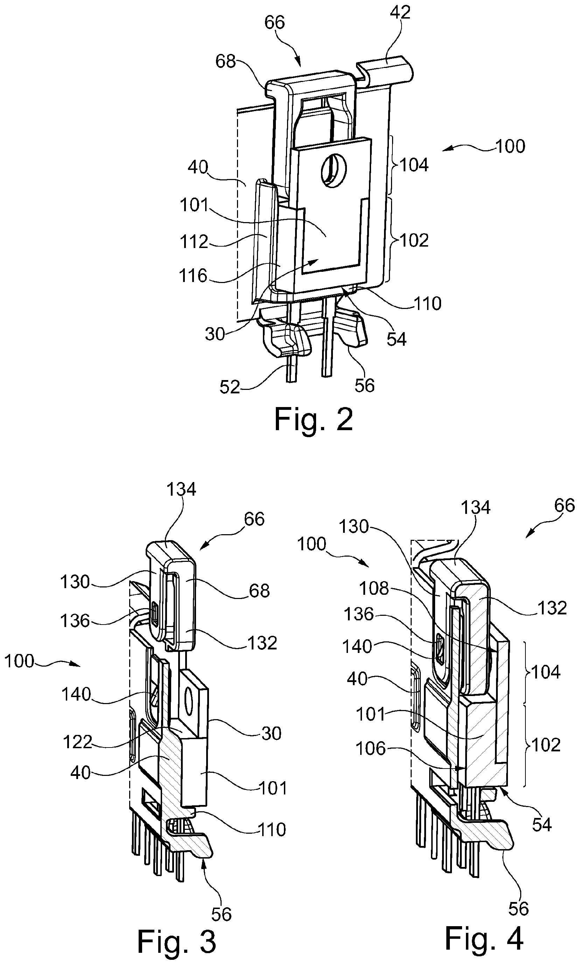

Figures 2 to 4 illustrate a first embodiment of a fixing device 100 configured to fix a first-type component 101 whose body has a lower section and an upper section hereinafter referred respectively to a main portion 102 and an upper portion 104. The back surface 30 of the body is shared by both the main and upper portions. The main portion 102 has a substantially flat front face 106 configured to be in contact with the plate 40. Similarly, the upper portion 104 has a substantially flat front face 108 which is substantially parallel to the back surface of the main portion. The thickness of the main portion is higher than the thickness of the upper portion such that the front face 108 of the upper portion is not in contact with the plate 40.

For example, the component of the first type comprises a well-known TO-220 package which comprises a metal tab with a hole. One of the face of the metal tab forms the back surface configured to be in contact with the heatsink.

As indicated hereinbefore, the plate 40 comprises abutments defining a receiving area for receiving the component.

Advantageously, the abutments are in contact with at least a portion of a periphery of the component when the component is received in the receiving area.

Preferably, the abutments comprise a horizontal abutment 110 protruding from the face of the plate configured to be in contact with the component and configured to contact a bottom surface 54 of the component 12 when the component is received by the plate.

Moreover, the abutments comprise at least two vertical abutments 112, each protruding from the face of the plate 40 configured to be in contact with the component and each configured to contact a lateral surface 116 of the component when the component is received by the plate.

Thanks to these vertical and horizontal abutments, the component is precisely positioned relative to the plate and cannot move relative to the plate. More particularly, any sliding movement downwardly in direction of the support is avoided and any tipping movement in a plane parallel to the plate is also avoided.

Furthermore, in order to avoid any sliding movement upwardly of the element, the abutments can comprise another horizontal abutment arranged on the plate and configured to contact an upper surface 122 of the main portion 102 of the component when the component is received by the plate.

As indicated hereinbefore, the fixing device 10 comprises at least a fixing element configured to fix the component against the plate 40 of the fixing device.

Advantageously, the fixing element comprises an element 66 configured to be arranged on the plate 40 to contact a periphery of the component, preferably the upper surface 122 of the main portion 102 of the component, when the component is received in the receiving area in order to maintain the component on the plate.

The element 66 comprises a clamp 68 element having a C-shape configured to clamp the plate and to block the upper surface 122 of the main portion 102 of the component such that the clamp 68 forms the other horizontal abutment as described hereinbefore. The clamp comprises two elongate arm segments 130, 132 connected to each other by means of a joint section 134. The clamp is made in an elastic material and the arm segments 130, 132 are spaced to each other by a distance configured such that the joint section 134 exerts an elastic force causing the two arm segments 130, 132 to be pushed one against the other when the clamp clamps an upper portion of the plate.

Furthermore, the clamp can further comprise a through-hole 136 receiving a pin 140 protruding from the plate when the clamp is mounted to block the clamp. More particularly, after the component is received by the receiving area of the plate in abutment against the horizontal and vertical abutments 110, 112, the clamp is installed on the plate by sliding in direction to the second end of the plate as illustrated in figure 3. As one arm segment is in contact with the upper surface 122 of the main portion 102 of the component, the pin 140 is engaged with the corresponding through-hole 136 of the clamp in a lock position as illustrated in figure 4.

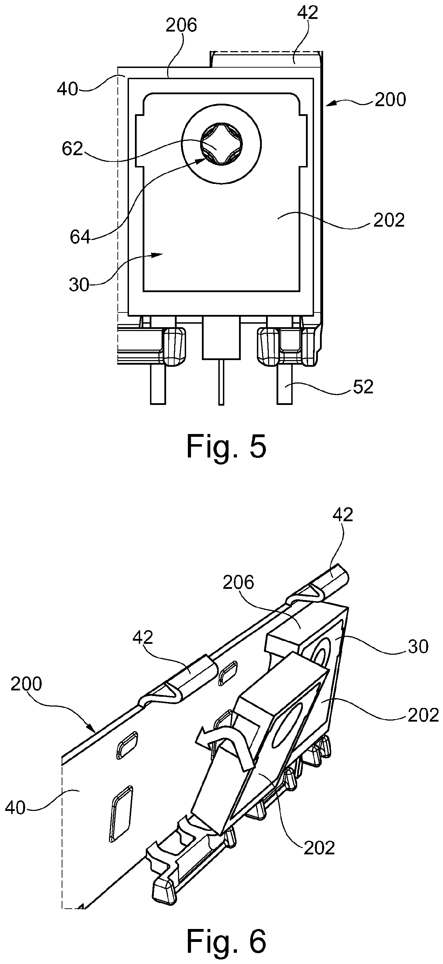

Figures 5 and 6 illustrate a second embodiment of a fixing device 200 configured to fix a second-type component 202 whose body, on the contrary to the first-type component, comprises a single portion having substantially constant thickness between the front surface 34 and the back surface 30. For example, the component of the second type comprises a well-known TO-246 package.

Such component comprises a hole 64 extending from the front surface 34 to the back surface 30.

As indicated hereinbefore, the fixing element comprises a pin 62 extending from the face of the plate 40 configured to be in contact with the component. Said pin 62 is configured to be inserted in the hole 64 of the component 202 and dimensioned such that the component is maintained against the plate 40. Advantageously, the component is maintained by a friction force between said pin 62 and the hole 64. Thus, the pin 62 of the fixing element forms abutments defining a receiving area for receiving the component and avoiding sliding or tipping movements of the component when the component is mounted on the plate.

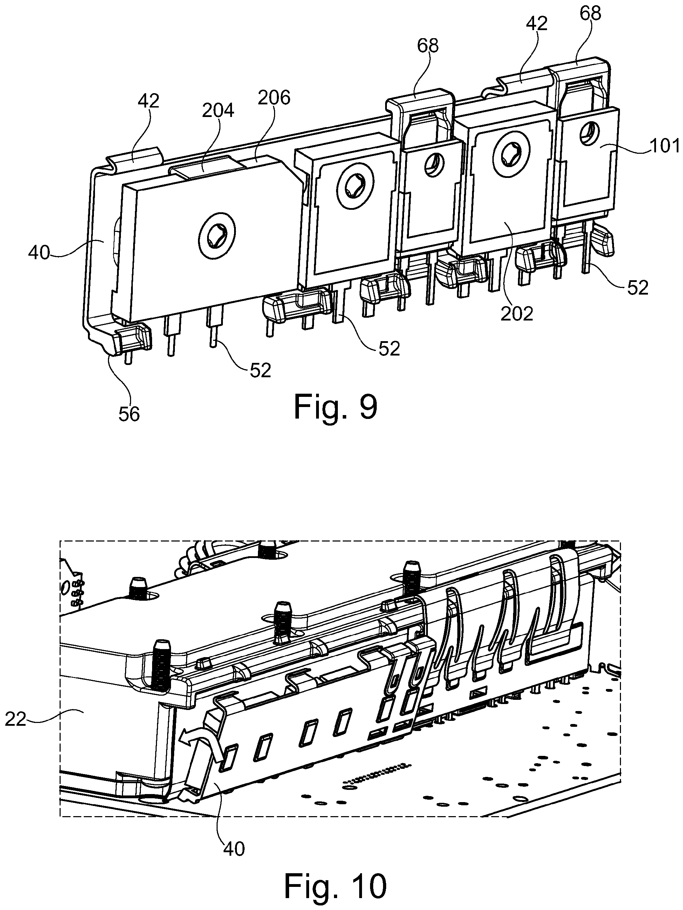

Moreover, the fixing device can comprise an upper horizontal abutment 204 configured to contact an upper surface 206 of the component when the component is received by the plate and thus avoiding tipping movements of the component when the component is mounted on the plate as illustrated on figure 10.

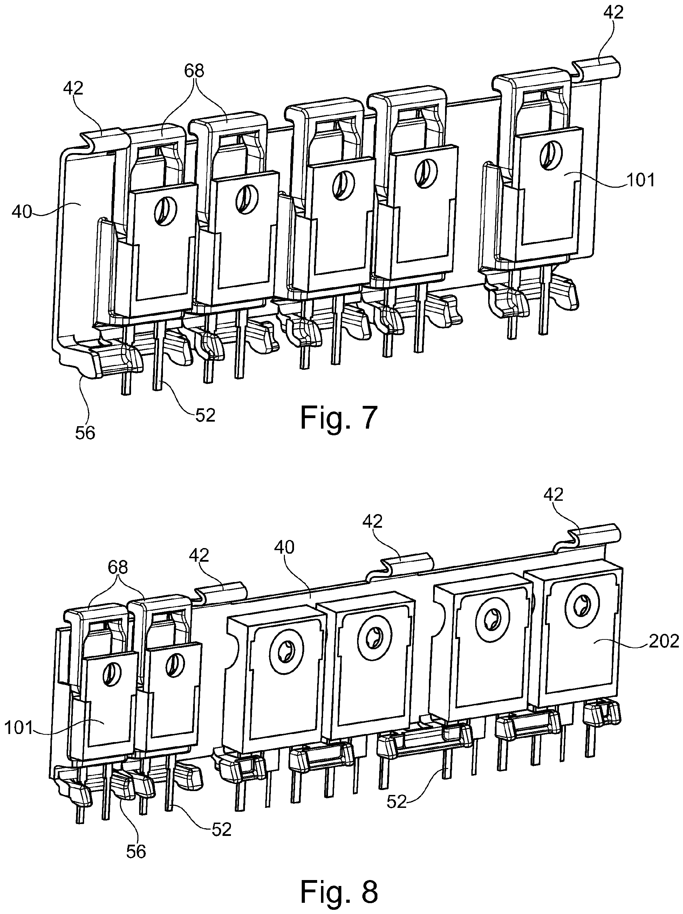

Figures 7 to 9 represent other embodiments of a fixing device according to the invention, wherein the fixing device is configured to fix several components of one or different types against an element.

For example, figure 7 illustrate an embodiment of a fixing device 300 configured to fix five components of the first-type as described hereinbefore.

For another example shown on figure 8, the fixing device 400 according to another embodiment of the invention is configured to fix six components: two of these components are of the first-type and the other four are of the second-type as described hereinbefore.

Another example is illustrated on figure 9, wherein the fixing device 500 according to the invention is configured to fix five components: two of these components are of the first-type and the others are of the second-type as described hereinbefore. Among the three components of the second-type, one is larger than the other ones and is advantageously maintained in position by an upper horizontal abutment as described hereinbefore.

Another object of the invention relates to a method for assembling such a component against such an element thanks to a fixing device as described hereinbefore.

More particularly, a method for fixing a component against an element on a support will now be detailed.

After providing the element 20, the or each component 12, the fixing device 10 and the support 16 on which the component is configured to be mounted, the component 12 is fixed against the plate 40 of the fixing device.

For example, the or each component 12 is positioned in a corresponding receiving area defined by the abutments of the plate 40. In another example compatible with the previous one, the or each component 12 is fixed against the plate 40 by a fixing element, by inserting a pin 62 in a hole 64 of the or each component 12 configured to maintain each component against the plate 40.

Then, the assembly formed by the plate and the component(s) are positioned relative to the support such that the free extremity of the or each rod of the component(s) are aligned with a corresponding through-hole of the support.

The free extremity of the or each rod is thus introduced into the corresponding through-hole of the support such that the second end of the fixing device comes into contact with the support.

As illustrated in figure 10 the plate 40 is then pivoted around the second end 48 such that the back face 30 of the component contacts the side wall 32 of the element.

As the assembly and more particularly the back face 30 of the component is in contact with the side wall 32 of the element 20, here the heatsink 22, the retaining element 42 of the fixing device 10 is engaged with the complementary retaining element 46 of the element 20 to a position in which a back face 30 of the component contacts and presses a side wall 32 of the element 20.

Optionally if the fixing device 10 further comprises a pressing device 80 as described hereinbefore, the pressing device 80 is installed for pressing the component against the side wall of the element.

Advantageously, the pressing device is installed according to a vertical direction, i.e. a direction perpendicular to the top wall of the element in order to have one simple assembly method for several components and not conflict with neighbouring components during the assembly.

Thanks to the invention, a fixing device is provided which is reliable, compact and can be easily assembled without the use of special tools.

While preferred embodiments of the invention have been described above, it is to be understood that variations and modifications will be apparent to those skilled in the art without departing from the scope of the invention which is defined by the appended claims.

## Claims

1. Fixing device (10) for fixing a component (12) configured to be mounted on a support (16) against an element (20) protruding from said support (16), the fixing device comprising:
- a plate (40) configured to receive the component (12) along a surface (34) of the component (12), and
- a retaining element (42) arranged on a first end (44) of the plate (40), and configured to cooperate with a complementary retaining element (46) of the element (20) to fix the component (12) against the element when the component is mounted on the support (16), the component (12) being disposed between the plate (40) and the element (20),
wherein the plate (40) comprises a second end (48), notably opposite from the first end (44), configured to receive a portion (52) of the component (12) so that said portion protrudes from the plate (40) for an insertion into a hole (50) in the support (16) when mounting the component on the support (16), and
**characterized by** the second end (48) of the plate which has a cross-section comprising at least a cylindrical portion (54) configured to allow a pivot of the plate (40) between a first position wherein the angle formed between the plate and the support is different from zero to a second position wherein the plate is substantially perpendicular to the support.

2. Fixing device according to claim 1, further comprising a pressing device (80) configured to exert a force to press the component (12) against the side wall (32) of the element (20) when the component (12) is mounted on the support (16).

3. Fixing device according to claim 1 or 2, wherein said second end (48) is configured to guide at least a rod (52) extending beyond a lower face (54) of the component (12) and configured to be inserted into a through-hole (50) of the support (16).

4. Fixing device according to any of the preceding claims, wherein an outer wall of the cylindrical portion (54) defines a pivot surface along which the plate (40) is configured to pivot between a first position wherein the angle formed between the plate and the support is different from zero to a second position wherein the plate is substantially perpendicular to the support.

5. Fixing device according to any of the preceding claims, wherein the plate (40) comprises abutments (110, 112; 62) defining a receiving area for receiving the component (12).

6. Fixing device according to the preceding claim, wherein said abutments (110, 112) are in contact with at least a portion (54, 116, 122) of a periphery of the component (12) when the component is received in the receiving area.

7. Fixing device according to any of the preceding claims, further comprising at least a fixing element configured to fix the component against the plate (40) of the fixing device.

8. Fixing device according to the preceding claim, wherein:
- the component (12) comprises a back surface (30) configured to contact the side wall (32) of the element (20) when the component is mounted on the support, a front surface (34) opposed to the back surface, and a hole (64) extending from the front surface to the back surface; and
- the fixing element comprises a pin (62) extending from the face of the plate (40) configured to be in contact with the component, said pin (62) being configured to be inserted in the hole (64) of the component and dimensioned such that the component is maintained against the plate.

9. Fixing device according to the preceding claim, wherein the component is maintained by a friction force between said pin (62) and the hole (64).

10. Fixing device according to any of claims 7 to 9, wherein the fixing element comprises an element (66) configured to be arranged on the plate (40) to contact a periphery of the component when the component is received in the receiving area in order to maintain the component on the plate (40).

11. Fixing device according to claim 10, wherein the element (66) comprises a clamp element (68) having a C-shape configured to clamp the plate (40) and to block an upper end (70) of the component.

12. Fixing device according to claim 11, wherein the clamp element (68) comprises a through hole (136) receiving a pin (140) protruding from the plate when the clamp element is mounted to block the clamp element.

13. Fixing device according to any of the preceding claims, wherein the retaining element (42) at the first end (44) of the plate comprises a resilient lip configured to cooperate with a groove comprised in the complementary retaining element (46) of the element (20).

14. Fixing device according to any of the preceding claims, wherein the component is an electronic component (14), the element is an heatsink (22) and the plate (40) is an electronic board, the electronic component (14) being mounted on the electronic board (18) against the heatsink (22) protruding from said electronic board (14).

15. Fixing device according to preceding claim 14 when it depends on claim 3 for fixing an electronic component (14) having at least an electrode forming the rod (52).

16. Method for fixing a component against an element on a support, the element comprising a fixing device (10) according to any of the preceding claims 1 to 15, wherein the fixing device (10) further comprises a pressing device (80) configured to exert a force to press the component (12) against the side wall (32) of the element (20) when the component is mounted on the support (16), the method comprising at least the steps of:
a) providing the element (12), the component (20), the fixing device (10) and the support (16) on which the component is configured to be mounted;
b) fixing the component (12) against the plate (40) of the fixing device;
c) engaging the retaining element (42) with the complementary retaining element (46) of the element (20) to a position in which a back face (30) of the component contacts a side wall (32) of the element (20); and
d) pressing the component against the side wall of the element with the pressing device, after the step of engaging the retaining element of the plate with the complementary retaining element of the element.

17. Method for fixing a component against an element according to claim 16, wherein the component (12) comprises at least a rod (52) extending beyond a lower face (54) of the component and configured to be inserted into a through-hole (50) of the support (16), the method further comprises a step of inserting the or each rod of the component into corresponding through-holes of the support before the step of engaging the retaining element of the plate with the complementary retaining element of the element.

18. Method for fixing a component against an element according to claim 17, wherein the plate (40) comprises a second end (48) notably opposite from the first end (44), and wherein the step of inserting the or each rod of the component into corresponding through-holes of the support comprises at least the steps of:
- positioning the fixing device (10) such that the free extremity of the or each rod of the component are aligned with a corresponding through-hole of the support;
- introducing the free extremity of the or each rod of the component into a corresponding through-hole of the support such that the second end of the fixing device comes into contact with the support; and
- pivoting the plate (40) of the fixing device (10) around the second end such that the back face (30) of the component contacts the side wall (32) of the element.

## Patentansprüche

1. Befestigungsvorrichtung (10) zum Befestigen einer Komponente (12), die dazu ausgelegt ist, auf einer Halterung (16) an einem aus der Halterung (16) hervorstehenden Element (20) montiert zu werden, wobei die Befestigungsvorrichtung umfasst:
- eine Platte (40), die dazu ausgelegt ist, die Komponente (12) entlang einer Fläche (34) der Komponente (12) aufzunehmen, und
- ein Rückhalteelement (42), das auf einem ersten Ende (44) der Platte (40) angeordnet und dazu ausgelegt ist, mit einem komplementären Rückhalteelement (46) des Elements (20) zusammenzuwirken, um die Komponente (12) an dem Element zu befestigen, wenn die Komponente auf der Halterung (16) montiert ist, wobei die Komponente (12) zwischen der Platte (40) und dem Element (20) angeordnet ist,
wobei die Platte (40) ein zweites Ende (48), insbesondere gegenüber von dem ersten Ende (44), umfasst, das dazu ausgelegt ist, einen Abschnitt (52) der Komponente (12) derart aufzunehmen, dass der Abschnitt von der Platte (40) zum Einsetzen in eine Öffnung (50) in der Halterung (16) bei Montieren der Komponente auf der Halterung (16) hervorsteht, und
**gekennzeichnet durch** das zweite Ende (48) der Platte, das einen Querschnitt aufweist, der mindestens einen zylindrischen Abschnitt (54) umfasst, der dazu ausgelegt ist, ein Schwenken der Platte (40) zwischen einer ersten Position, in der der zwischen der Platte und der Halterung gebildete Winkel ungleich Null ist, zu einer zweiten Position, in der die Platte im Wesentlichen senkrecht zu der Halterung steht, zu ermöglichen.

2. Befestigungsvorrichtung nach Anspruch 1, ferner umfassend eine Andrückvorrichtung (80), die dazu ausgelegt ist, eine Kraft zum Andrücken der Komponente (12) an die Seitenwand (32) des Elements (20) auszuüben, wenn die Komponente (12) auf der Halterung (16) montiert ist.

3. Befestigungsvorrichtung nach Anspruch 1 oder 2, wobei das zweite Ende (48) dazu ausgelegt ist, mindestens einen Stab (52) zu führen, der sich über eine untere Fläche (54) der Komponente (12) hinaus erstreckt und dazu ausgelegt ist, in eine Durchgangsöffnung (50) der Halterung (16) eingesetzt zu sein.

4. Befestigungsvorrichtung nach einem der vorhergehenden Ansprüche, wobei eine Außenwand des zylindrischen Abschnitts (54) eine Schwenkfläche definiert, entlang derer die Platte (40) dazu ausgelegt ist, zwischen einer ersten Position, in der der zwischen der Platte und der Halterung gebildete Winkel ungleich Null ist, zu einer zweiten Position, in der die Platte im Wesentlichen senkrecht zu der Halterung steht, zu schwenken.

5. Befestigungsvorrichtung nach einem der vorhergehenden Ansprüche, wobei die Platte (40) Auflager (110, 112; 62) umfasst, die einen Aufnahmebereich zum Aufnehmen der Komponente (12) bilden.

6. Befestigungsvorrichtung nach dem vorhergehenden Anspruch, wobei die Auflager (110, 112) mit mindestens einem Abschnitt (54, 116, 122) eines Umfangs der Komponente (12) in Kontakt stehen, wenn die Komponente in dem Aufnahmebereich aufgenommen ist.

7. Befestigungsvorrichtung nach einem der vorhergehenden Ansprüche, ferner umfassend mindestens ein Befestigungselement, das dazu ausgelegt ist, die Komponente an der Platte (40) der Befestigungsvorrichtung zu befestigen.

8. Befestigungsvorrichtung nach dem vorhergehenden Anspruch, wobei:
- die Komponente (12) eine Rückfläche (30), die dazu ausgelegt ist, mit der Seitenwand (32) des Elements (20) in Kontakt zu kommen, wenn die Komponente auf der Halterung montiert ist, eine Frontfläche (34), die der Rückfläche gegenüberliegt, und eine Öffnung (64), die sich von der Frontfläche zu der Rückfläche erstreckt, umfasst; und
- das Befestigungselement einen Stift (62) umfasst, der sich von der Fläche der Platte (40) erstreckt, die dazu ausgelegt ist, mit der Komponente in Kontakt zu stehen, wobei der Stift (62) dazu ausgelegt ist, in die Öffnung (64) der Komponente eingesetzt und derart dimensioniert zu sein, dass die Komponente an der Platte gehalten wird.

9. Befestigungsvorrichtung nach dem vorhergehenden Anspruch, wobei die Komponente durch eine Reibungskraft zwischen dem Stift (62) und der Öffnung (64) gehalten wird.

10. Befestigungsvorrichtung nach einem der Ansprüche 7 bis 9, wobei das Befestigungselement ein Element (66) umfasst, das dazu ausgelegt ist, auf der Platte (40) derart angeordnet zu sein, dass es mit einem Umfang der Komponente in Kontakt kommt, wenn die Komponente in dem Aufnahmebereich aufgenommen ist, um die Komponente auf der Platte (40) zu halten.

11. Befestigungsvorrichtung nach Anspruch 10, wobei das Element (66) ein Spannelement (68) mit einer C-Form umfasst, das dazu ausgelegt ist, die Platte (40) einzuspannen und ein oberes Ende (70) der Komponente zu blockieren.

12. Befestigungsvorrichtung nach Anspruch 11, wobei das Spannelement (68) eine Durchgangsöffnung (136) umfasst, die einen von der Platte hervorstehenden Stift (140) aufnimmt, wenn das Spannelement montiert ist, um das Spannelement zu blockieren.

13. Befestigungsvorrichtung nach einem der vorhergehenden Ansprüche, wobei das Rückhalteelement (42) an dem ersten Ende (44) der Platte eine elastische Lippe umfasst, die dazu ausgelegt ist, mit einer in dem komplementären Rückhalteelement (46) des Elements (20) enthaltenen Nut zusammenzuwirken.

14. Befestigungsvorrichtung nach einem der vorhergehenden Ansprüche, wobei die Komponente eine Elektronikkomponente (14) ist, das Element eine Wärmesenke (22) ist und die Platte (40) eine Elektronikplatine ist, wobei die Elektronikkomponente (14) auf der Elektronikplatine (18) an der von der Elektronikplatine (14) hervorstehenden Wärmesenke (22) montiert ist.

15. Befestigungsvorrichtung nach dem vorhergehenden Anspruch 14, wenn abhängig von Anspruch 3, zum Befestigen einer Elektronikkomponente (14) mit mindestens einer Elektrode, die den Stab (52) bildet.

16. Verfahren zum Befestigen einer Komponente an einem Element auf einer Halterung, wobei das Element eine Befestigungsvorrichtung (10) nach einem der vorhergehenden Ansprüche 1 bis 15 umfasst, wobei die Befestigungsvorrichtung (10) ferner eine Andrückvorrichtung (80) umfasst, die dazu ausgelegt ist, eine Kraft zum Andrücken der Komponente (12) an die Seitenwand (32) des Elements (20) auszuüben, wenn die Komponente auf der Halterung (16) montiert ist, wobei das Verfahren mindestens die folgenden Schritte umfasst:
a) Bereitstellen des Elements (12), der Komponente (20), der Befestigungsvorrichtung (10) und der Halterung (16), auf der die Komponente ausgelegt ist, montiert zu sein;
b) Befestigen der Komponente (12) an der Platte (40) der Befestigungsvorrichtung;
c) Ineingriffbringen des Rückhalteelements (42) mit dem komplementären Rückhalteelement (46) des Elements (20) bis zu einer Position, in der eine Rückfläche (30) der Komponente mit einer Seitenwand (32) des Elements (20) in Kontakt kommt; und
d) Andrücken der Komponente an die Seitenwand des Elements mit der Andrückvorrichtung nach dem Schritt zum Ineingriffbringen des Rückhalteelements der Platte mit dem komplementären Rückhalteelement des Elements.

17. Verfahren zum Befestigen einer Komponente an einem Element nach Anspruch 16, wobei die Komponente (12) mindestens einen Stab (52) umfasst, der sich über eine untere Fläche (54) der Komponente hinaus erstreckt und dazu ausgelegt ist, in eine Durchgangsöffnung (50) der Halterung (16) eingesetzt zu sein, wobei das Verfahren ferner einen Schritt zum Einsetzen des oder jedes Stabs der Komponente in entsprechende Durchgangsöffnungen der Halterung vor dem Schritt zum Ineingriffbringen des Rückhalteelements der Platte mit dem komplementären Rückhalteelement des Elements umfasst.

18. Verfahren zum Befestigen einer Komponente an einem Element nach Anspruch 17, wobei die Platte (40) ein zweites Ende (48), insbesondere gegenüber von dem ersten Ende (44), umfasst, und wobei der Schritt zum Einsetzen des oder jedes Stabs der Komponente in entsprechende Durchgangsöffnungen der Halterung mindestens die folgenden Schritte umfasst:
- Positionieren der Befestigungsvorrichtung (10) derart, dass das freie äußerste Ende des oder jedes Stabs der Komponente mit einer entsprechenden Durchgangsöffnung der Halterung ausgerichtet wird;
- Einführen des freien äußersten Endes des oder jedes Stabs der Komponente in eine entsprechende Durchgangsöffnung der Halterung derart, dass das zweite Ende der Befestigungsvorrichtung mit der Halterung in Kontakt kommt; und
- Schwenken der Platte (40) der Befestigungsvorrichtung (10) um das zweite Ende derart, dass die Rückfläche (30) der Komponente mit der Seitenwand (32) des Elements in Kontakt kommt.

## Revendications

1. Dispositif de fixation (10) pour fixer un composant (12) configuré pour être monté sur un support (16) contre un élément (20) faisant saillie à partir dudit support (16), le dispositif de fixation comprenant :
- une plaque (40) configurée pour recevoir le composant (12) le long d'une surface (34) du composant (12), et
- un élément de retenue (42) agencé sur une première extrémité (44) de la plaque (40), et configuré pour coopérer avec un élément de retenue complémentaire (46) de l'élément (20) pour fixer le composant (12) contre l'élément lorsque le composant est monté sur le support (16), le composant (12) étant disposé entre la plaque (40) et l'élément (20),
dans lequel la plaque (40) comprend une seconde extrémité (48), notamment opposée par rapport à la première extrémité (44), configurée pour recevoir une partie (52) du composant (12) pour que ladite partie fasse saillie à partir de la plaque (40) pour une insertion dans un trou (50) dans le support (16) lors du montage du composant sur le support (16), et
**caractérisé par** la seconde extrémité (48) de la plaque qui a une section transversale comprenant au moins une partie cylindrique (54) configurée pour permettre un pivotement de la plaque (40) entre une première position dans laquelle l'angle formé entre la plaque et le support est différent de zéro et une seconde position dans laquelle la plaque est sensiblement perpendiculaire au support.

2. Dispositif de fixation selon la revendication 1, comprenant en outre un dispositif de pression (80) configuré pour exercer une force pour presser le composant (12) contre la paroi latérale (32) de l'élément (20) lorsque le composant (12) est monté sur le support (16).

3. Dispositif de fixation selon la revendication 1 ou 2, dans lequel ladite seconde extrémité (48) est configurée pour guider au moins une tige (52) s'étendant au-delà d'une face inférieure (54) du composant (12) et configurée pour être insérée dans un trou débouchant (50) du support (16).

4. Dispositif de fixation selon l'une quelconque des revendications précédentes, dans lequel une paroi extérieure de la partie cylindrique (54) définit une surface de pivotement le long de laquelle la plaque (40) est configurée pour pivoter entre une première position dans laquelle l'angle formé entre la plaque et le support est différent de zéro et une seconde position dans laquelle la plaque est sensiblement perpendiculaire au support.

5. Dispositif de fixation selon l'une quelconque des revendications précédentes, dans lequel la plaque (40) comprend des butées (110, 112 ; 62) définissant une zone de réception pour recevoir le composant (12).

6. Dispositif de fixation selon la revendication précédente, dans lequel lesdites butées (110, 112) sont en contact avec au moins une partie (54, 116, 122) d'une périphérie du composant (12) lorsque le composant est reçu dans la zone de réception.

7. Dispositif de fixation selon l'une quelconque des revendications précédentes, comprenant en outre au moins un élément de fixation configuré pour fixer le composant contre la plaque (40) du dispositif de fixation.

8. Dispositif de fixation selon la revendication précédente, dans lequel :
- le composant (12) comprend une surface arrière (30) configurée pour entrer en contact avec la paroi latérale (32) de l'élément (20) lorsque le composant est monté sur le support, une surface avant (34) opposée à la surface arrière, et un trou (64) s'étendant depuis la surface avant jusqu'à la surface arrière ; et
- l'élément de fixation comprend une broche (62) s'étendant depuis la face de la plaque (40) configurée pour être en contact avec le composant, ladite broche (62) étant configurée pour être insérée dans le trou (64) du composant et dimensionnée de telle sorte que le composant soit maintenu contre la plaque.

9. Dispositif de fixation selon la revendication précédente, dans lequel le composant est maintenu par une force de friction entre ladite broche (62) et le trou (64).

10. Dispositif de fixation selon l'une quelconque des revendications 7 à 9, dans lequel l'élément de fixation comprend un élément (66) configuré pour être agencé sur la plaque (40) pour entrer en contact avec une périphérie du composant lorsque le composant est reçu dans la zone de réception afin de maintenir le composant sur la plaque (40).

11. Dispositif de fixation selon la revendication 10, dans lequel l'élément (66) comprend un élément de serrage (68) ayant une forme de C configuré pour serrer la plaque (40) et pour bloquer une extrémité supérieure (70) du composant.

12. Dispositif de fixation selon la revendication 11, dans lequel l'élément de serrage (68) comprend un trou débouchant (136) recevant une broche (140) faisant saillie à partir de la plaque lorsque l'élément de serrage est monté pour bloquer l'élément de serrage.

13. Dispositif de fixation selon l'une quelconque des revendications précédentes, dans lequel l'élément de retenue (42) à la première extrémité (44) de la plaque comprend une lèvre résiliente configurée pour coopérer avec une rainure comprise dans l'élément de retenue complémentaire (46) de l'élément (20).

14. Dispositif de fixation selon l'une quelconque des revendications précédentes, dans lequel le composant est un composant électronique (14), l'élément est un dissipateur de chaleur (22) et la plaque (40) est une carte électronique, le composant électronique (14) étant monté sur la carte électronique (18) contre le dissipateur de chaleur (22) faisant saillie à partir de ladite carte électronique (14).

15. Dispositif de fixation selon la revendication précédente 14 lorsqu'elle dépend de la revendication 3, pour fixer un composant électronique (14) ayant au moins une électrode formant la tige (52).

16. Procédé pour fixer un composant contre un élément sur un support, l'élément comprenant un dispositif de fixation (10) selon l'une quelconque des revendications précédentes 1 à 15, dans lequel le dispositif de fixation (10) comprend en outre un dispositif de pression (80) configuré pour exercer une force pour presser le composant (12) contre la paroi latérale (32) de l'élément (20) lorsque le composant est monté sur le support (16), le procédé comprenant au moins les étapes de :
a) la fourniture de l'élément (12), du composant (20), du dispositif de fixation (10) et du support (16) sur lequel le composant est configuré pour être monté ;
b) la fixation du composant (12) contre la plaque (40) du dispositif de fixation ;
c) la mise en prise de l'élément de retenue (42) avec l'élément de retenue complémentaire (46) de l'élément (20) jusqu'à une position dans laquelle une face arrière (30) du composant entre en contact avec une paroi latérale (32) de l'élément (20) ; et
d) la pression du composant contre la paroi latérale de l'élément avec le dispositif de pression, après l'étape de la mise en prise de l'élément de retenue de la plaque avec l'élément de retenue complémentaire de l'élément.

17. Procédé pour fixer un composant contre un élément selon la revendication 16, dans lequel le composant (12) comprend au moins une tige (52) s'étendant au-delà d'une face inférieure (54) du composant et configurée pour être insérée dans un trou débouchant (50) du support (16), le procédé comprend en outre une étape de l'insertion de la ou de chaque tige du composant dans des trous débouchants correspondants du support avant l'étape de la mise en prise de l'élément de retenue de la plaque avec l'élément de retenue complémentaire de l'élément.

18. Procédé pour fixer un composant contre un élément selon la revendication 17, dans lequel la plaque (40) comprend une seconde extrémité (48) notamment opposée par rapport à la première extrémité (44), et dans lequel l'étape de l'insertion de la ou de chaque tige du composant dans des trous débouchants correspondants du support comprend au moins les étapes de :
- le positionnement du dispositif de fixation (10) de telle sorte que le bout libre de la ou de chaque tige du composant soit aligne avec un trou débouchant correspondant du support ;
- l'introduction du bout libre de la ou de chaque tige du composant dans un trou débouchant correspondant du support de telle sorte que la seconde extrémité du dispositif de fixation entre en contact avec le support ; et
- le pivotement de la plaque (40) du dispositif de fixation (10) autour de la seconde extrémité de telle sorte que la face arrière (30) du composant entre en contact avec la paroi latérale (32) de l'élément.
